# DEMANDE DE BREVET EUROPEEN

(11) **EP 2 048 261 A1**
(43) Date de publication de la demande: **15.04.2009**
(21) Numéro de dépôt: 07447056.8
(22) Date de dépôt: 12.10.2007
(51) Int. Cl.: C23C 14/16, C23C 14/24, C23C 14/56

(54) **Générateur de vapeur industriel pour le dépôt d'un revêtement d'alliage sur une bande métallique**

(71) Demandeur: ArcelorMittal France, 93200 Saint-Denis (FR)
(72) Inventeur: Banaszak, Pierre, 4683 Vivegnis (BE); Marneffe, Didier, 4480 Engis (BE); Silberberg, Eric, 5340 Haltinne-Gesves (BE); Vanhee, Luc, 08600 Fromelennes (FR)
(74) Mandataire: pronovem

(57) **Abrégé**

La présente invention se rapporte à un générateur de vapeur pour le dépôt d'un revêtement métallique sur un substrat (7), de préférence une bande d'acier, comprenant une chambre à vide (6) sous forme d'une enceinte, munie de moyens pour y assurer un état de dépression par rapport au milieu extérieur et munie de moyens permettant l'entrée et la sortie du substrat (7), tout en étant essentiellement étanche par rapport au milieu extérieur, ladite enceinte englobant une tête de dépôt de vapeur, appelée éjecteur (3), conformé pour créer un jet de vapeur métallique à la vitesse sonique en direction de et perpendiculaire à la surface du substrat (7), ledit éjecteur (3) étant en communication de manière étanche au moyen d'une conduite d'alimentation (4) avec au moins un creuset (1) contenant un métal de revêtement sous forme liquide et situé à l'extérieur de la chambre à vide (6), caractérisé en ce que ledit générateur de vapeur comprend des moyens pour réguler le débit, la pression et/ou la vitesse de la vapeur métallique dans l'éjecteur (3).

## Description

### Objet de l'invention

La présente invention se rapporte à un générateur de vapeur industriel pour revêtir sous vide et en continu un substrat en mouvement, plus particulièrement une bande métallique, au moyen d'une vapeur métallique en vue de former une couche de métal et de préférence une couche d'alliage métallique sur sa surface, de manière à lui assurer une excellente résistance à la corrosion tout en conservant de bonnes caractéristiques d'emboutissage et de soudabilité.

### Etat de la technique

Il est connu depuis la fin des années 1980 que le dépôt de certains alliages, tels que ZnMg, à la surface d'une bande d'acier, a un rôle protecteur de l'acier. L'excellente tenue en corrosion de l'alliage ZnMg est attribuée à la nature des produits de corrosion formés à la surface de la bande selon une couche extrêmement dense jouant le rôle de film-barrière.

Un tel dépôt d'alliage n'est généralement pas possible au moyen des techniques habituelles telles que le dépôt électrolytique, le revêtement au trempé, etc. Ainsi, à la pression atmosphérique, on peut avoir contamination du bain de métal liquide par l'oxygène de l'air, qui forme des oxydes à la surface du bain.

La seule issue possible est donc souvent l'évaporation sous vide du métal liquide, pur ou sous forme d'alliage (technique PVD, *Pressure Vapor Deposition*).

Dans le cadre de cette technique, il est connu de placer le substrat dans une enceinte sous vide maintenue à basse température et contenant un creuset de métal fondu. Le dépôt s'effectue alors sur toutes les parois dont la température est inférieure à la température de la vapeur métallique. Pour augmenter le rendement de dépôt sur le substrat et éviter les gaspillages, on a donc intérêt à chauffer les parois de l'enceinte.

Le document US-A-5,002,837 décrit le dépôt par évaporation d'un revêtement bicouche zn/ZnMg avec une phase totalement alliée Zn₂Mg ou Zn₂Mg/Zn₁₁Mg₂.

Dans le document EP-A-0 730 045, on décrit un revêtement de bande d'acier avec un dépôt de 3 ou 5 couches d'alliage ZnMg déposées sous vide et assurant une très bonne résistance à la corrosion avec un minimum de poudrage lors de l'emboutissage.

Dans le document WO-A-02/06558, un revêtement ZnMg est obtenu sous vide par co-évaporation à partir de deux creusets, l'un contenant le zinc et l'autre le magnésium. Avant projection sur la bande, les vapeurs sont mélangées dans un dispositif d'étranglement sous forme de plaques munies de trous ou fentes, qui permet d'obtenir une vitesse sonique et un débit de vapeur maximum.

Dans le document WO-A-02/14573, on décrit l'élaboration d'un revêtement à partir d'un revêtement zingué de base obtenu par un procédé conventionnel de galvanisation au trempé ou électrozingué, lui-même revêtu ensuite de magnésium sous vide. Un chauffage rapide par induction permet de remettre pendant quelques secondes le dépôt en fusion et d'obtenir après refroidissement, une répartition microstructurale favorable de phase alliée ZnMg dans toute l'épaisseur de la couche.

La Demanderesse a en outre proposé un produit industriel bicouche électro-zingué/alliage ZnMg obtenu par la voie PVD (EP-A-0 756 022), ainsi qu'une amélioration du procédé avec un système de chauffage infrarouge pour réaliser l'alliation du magnésium avec le zinc afin de minimiser la formation de phase intermétallique fragile FeZn.

Dans le document WO-A-97/47782, on décrit un procédé pour revêtir en continu un substrat en mouvement dans lequel la vapeur métallique est générée en chauffant par induction un creuset contenant un bain constitué par le métal de revêtement dans une enceinte sous vide. La vapeur s'échappe du creuset par une conduite qui l'amène vers un orifice de sortie, de préférence calibré, de manière à former un jet dirigé vers la surface du substrat à revêtir. L'utilisation d'un orifice sous forme d'une fente longitudinale de section étroite permet la régulation du débit massique de vapeur, à une vitesse sonique constante le long de la fente (col sonique), ce qui procure l'avantage d'obtenir un dépôt uniforme. On se référera par la suite à cette technique en utilisant l'acronyme « JVD » (pour *Jet Vapor Deposition*).

Cette technologie présente cependant plusieurs défauts, dont notamment :
- l'alimentation permanente en métal liquide implique de prévoir le retour à la cuve de celui-ci en un ou plusieurs points ;
- le métal liquide comprenant des impuretés, il y a concentration de ces impuretés en surface du bain suite à l'évaporation, ce qui réduit le débit. Une solution serait un écrémage de la surface ou un recyclage de la charge mais toute opération mécanique est rendue difficile sous vide ;
- la difficulté d'adapter la fente d'évaporation à une largeur de bande variable, ce qui implique des moyens d'occultation de part et d'autre de la fente, et partant la réalisation d'une étanchéité à la vapeur sous vide et à 700°C, ce qui n'est pas aisé à réaliser ;
- la difficulté d'occulter la fente lorsque le mouvement de la bande s'interrompt, ce qui impliquerait la présence d'une vanne linéaire étanche sur une longueur typique de 2 mètres ou plus ;
- la grande inertie thermique du système (au moins plusieurs minutes) ;
- le chauffage, réalisé par induction sous vide, nécessite de passer toute la puissance électrique de chauffage au travers de la paroi étanche au vide, ce qui ne facilite pas l'accessibilité et la maintenabilité de l'installation.

Par ailleurs, l'état de la technique n'apporte pas de solution satisfaisante à la nécessité de réaliser le co-dépôt de deux métaux distincts, impliquant le mélange de deux jets en sortie de l'évaporateur. L'utilisation de boîtes de mélange intermédiaires à chicanes n'a apporté aucun résultat probant.

Il est possible de réaliser des alliages de métal de revêtement (ex. 85% Zn, 15% Mg) en contrôlant rigoureusement la concentration des deux métaux dans le creuset. Toutefois ce contrôle implique de grandes difficultés de gestion du système, et en particulier l'homogénéité dans le creuset, surtout si celui-ci n'est pas de section circulaire.

On sait aussi que la société Sidrabe Inc. (Lettonie) a proposé par ailleurs un procédé PVD où la source de métal en fusion est déportée en dehors de la chambre de dépôt sous vide, initialement pour éviter qu'à haute vitesse d'évaporation, de fines particules de magnésium solide ne se déposent sur le substrat. La séparation de la zone de fusion de la boîte d'évaporation par une conduite de communication permet de réguler plus aisément l'évaporation. Une mesure de pression de vapeur est notamment effectuée au niveau de cette conduite (par ex. dans SVC 505/856-7188 42nd Annual Technical Conference Proceedings (1999), pp.39-42).

Le document WO-A-2005/116290 propose une installation de ce type où les niveaux de métal liquide respectifs dans le creuset de fusion et dans le creuset d'évaporation sont régulés au moyen d'une pompe magnétohydrodynamique.

### Buts de l'invention

La présente invention vise à fournir une solution qui permette de s'affranchir des inconvénients de l'état de la technique.

En particulier, l'invention vise à atteindre notamment les objectifs suivants :
- simplicité de réalisation ;
- accessibilité et maintenance aisées du ou des creusets ;
- excellente uniformité de l'évaporation et mécanisme simple d'adaptation sur des largeurs de bande pouvant excéder 2 mètres ;
- débit de vapeur maximalisé ;
- brassage magnétique élevé évitant la ségrégation des impuretés en surface ;
- régulation aisée du débit de vapeur, par contrôle de la puissance électrique et/ou de la température de surface d'évaporation ;
- installation possible et facilité procurée par des vannes dans des conduites cylindriques de diamètre réduit.

### Principaux éléments caractéristiques de l'invention

La présente invention se rapporte à un générateur de vapeur pour le dépôt d'un revêtement métallique sur un substrat, de préférence une bande d'acier, comprenant une chambre à vide sous forme d'une enceinte, munie de moyens pour y assurer un état de dépression par rapport au milieu extérieur et munie de moyens permettant l'entrée et la sortie du substrat, tout en étant essentiellement étanche par rapport au milieu extérieur, ladite enceinte englobant une tête de dépôt de vapeur, appelée éjecteur, conformé pour créer un jet de vapeur métallique à la vitesse sonique en direction de et perpendiculaire à la surface du substrat, ledit éjecteur étant en communication de manière étanche au moyen d'une conduite d'alimentation avec au moins un creuset contenant un métal de revêtement sous forme liquide et situé à l'extérieur de la chambre à vide, caractérisé en ce que ledit générateur de vapeur comprend des moyens pour réguler le débit, la pression et/ou la vitesse de la vapeur métallique dans l'éjecteur.

Selon l'invention, lesdits moyens de régulation comprennent une vanne et/ou un dispositif de perte de charge disposés dans ladite conduite.

Avantageusement, la vanne est une vanne proportionnelle, de préférence de type papillon.

De préférence, l'éjecteur comprend une fente longitudinale de sortie de la vapeur, jouant le rôle de col sonique, s'étendant sur toute la largeur du substrat et un milieu filtrant pouvant être un filtre fritté, de préférence en titane, de sorte à uniformiser et redresser les vecteurs vitesse de la vapeur sortant de la tête de dépôt.

Avantageusement, le générateur comporte des moyens pour ajuster la longueur de la fente à la largeur du substrat, ces moyens comprenant par exemple des moyens de rotation de l'éjecteur autour de sa conduite d'alimentation.

Selon une forme d'exécution alternative, le générateur de vapeur selon l'invention comporte un creuset contenant un mélange de métaux sous forme liquide.

Toujours selon l'invention, le creuset est alimenté par pompage ou par gravité du métal liquide à partir d'un four de fusion.

Avantageusement, le creuset comporte une purge vers le four de fusion par pompage ou écoulement gravitaire.

Toujours avantageusement, le creuset comporte des moyens de mesure de niveau. Une mesure de masse extérieure au creuset et un moyen qui a été utilisé selon l'invention pour réguler le niveau de métal liquide.

Selon une modalité d'exécution préférée de l'invention, l'éjecteur, la conduite et le creuset sont isolés thermiquement du milieu extérieur et chauffés par un four à rayonnement extérieur à ces organes. La chambre à vide peut rester froide ou maintenue chaude.

Selon une autre modalité d'exécution de l'invention, le générateur de vapeur comporte deux creusets contenant des métaux sous forme liquide différents, en vue de réaliser un dépôt d'alliage métallique sur le substrat.

Selon l'invention, chaque creuset est relié par une conduite propre à un mélangeur, lui-même en communication avec l'éjecteur.

Avantageusement, chaque conduite comporte une vanne et/ou un dispositif de perte de charge permettant l'ajustement des concentrations de chaque métal lors du mélange des vapeurs à déposer sur le substrat.

Selon une modalité préférée, le mélangeur est l'éjecteur lui-même et comporte un milieu filtrant pouvant être un filtre fritté permettant d'uniformiser et redresser les vecteurs vitesse de la vapeur de chaque métal sortant de l'éjecteur.

### Brève description des figures

Les figures 1A à 1C représentent schématiquement plusieurs exemples d'exécution du générateur de vapeur industriel selon la présente invention.

Les figures 2A et 2B représentent des détails d'exécution respectivement du creuset de métal liquide et de l'éjecteur de vapeur selon une modalité d'exécution préférée de la présente invention. La figure 2B illustre en particulier le système aisé d'adaptation du jet de vapeur à la largeur de la bande par simple rotation de l'éjecteur autour de son axe.

Les figures 3A à 3C représentent plusieurs vues de l'éjecteur de vapeur selon la présente invention, illustrant une répartition uniforme du métal vaporisé.

Les figures 4 et 5 représentent des résultats de simulation en mécanique des fluides pour la chambre d'évaporation précitée (respectivement température et vitesse de sortie).

La figure 6 montre une micrographie obtenue pour un dépôt de magnésium sur du fer noir obtenu avec une installation pilote selon la présente invention.

La figure 7 illustre un exemple de régulation de l'ouverture des vannes dans l'installation selon l'invention, ainsi que la vitesse de dépôt moyenne correspondante, au cours du temps pour une température du magnésium liquide égale à 690°C.

La figure 8 représente schématiquement un générateur de vapeur selon l'invention dans une forme d'exécution permettant un dépôt d'alliage de deux métaux purs sur le substrat.

### Description détaillée de l'invention

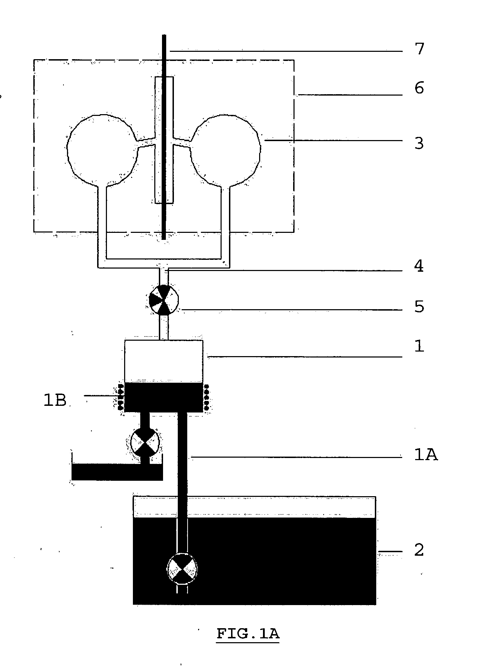

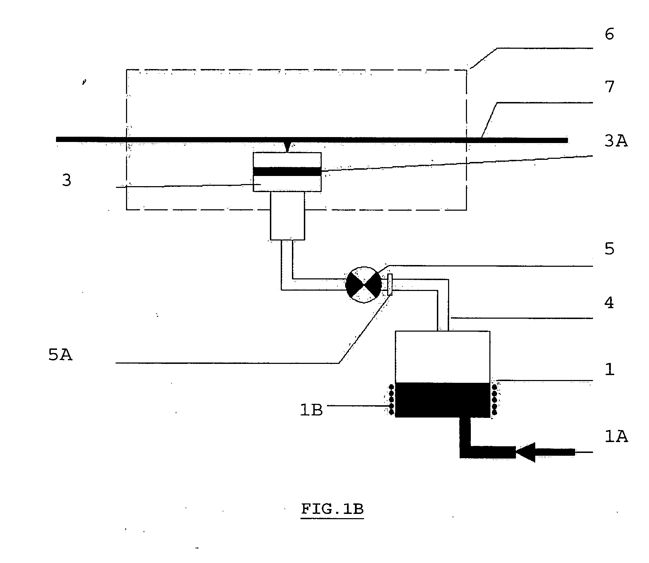

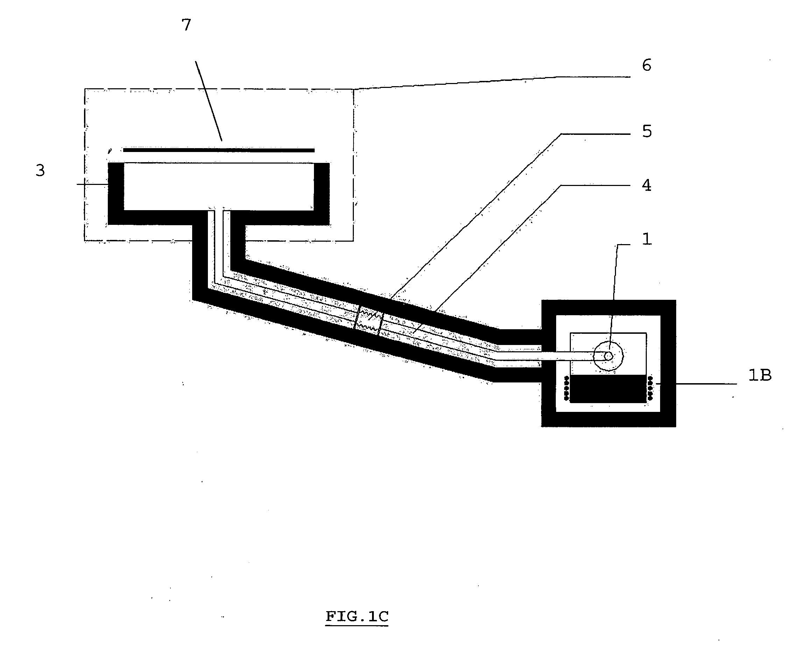

La solution préconisée selon la présente invention consiste à utiliser un creuset d'évaporation qui soit dissocié d'une tête d'évaporation JVD à fente longitudinale de sortie de vapeur, appelée ci-après éjecteur. Le principe général d'un tel dispositif est représenté sur la figure 1A. Une autre représentation schématique est donnée sur la figure 1B. La description d'ensemble d'une installation pilote est donnée à la figure 1C. Le creuset 1 est alimenté par une conduite 1A à partir d'un four de fusion de magnésium 2, avec décantation des impuretés. Le type de four de fusion et les conduites utilisés sont des matériels usuellement utilisés dans l'industrie de la fonderie et bien connus de l'homme de métier. Notamment, la fusion et le chargement dans l'appareil selon l'invention se font par des techniques éprouvées.

Le creuset 1 étant déporté et de forme cylindrique, une bonne uniformité de température peut être atteinte grâce à un brassage magnétique important. Le brassage magnétique assuré par un inducteur 1B monté sur ce creuset permet de conserver une homogénéité dans tout le creuset, les ségrégations d'impuretés non évaporées (décantation et flottaison) se faisant dans le four de fusion 2. On assure ainsi la constance dans le temps des conditions d'évaporation et donc de dépôt. Le brassage magnétique est ajusté par la fréquence d'induction en fonction de la nature du creuset et de sa taille.

Le creuset déporté est relié à l'éjecteur 3 (double sur la figure 1A), qui se trouve dans l'enceinte sous vide 6 dans laquelle passe la bande métallique 7, par une conduite cylindrique 4, dont la section est dimensionnée pour obtenir une vitesse lente (la vitesse à la sortie du creuset est idéalement de l'ordre du mètre par seconde à quelques dizaines de mètre par seconde).

L'utilisation d'une conduite cylindrique permet d'obtenir une bonne étanchéité à haute température et au vide en utilisant par exemple une vanne papillon 5 telle que disponible dans le commerce.

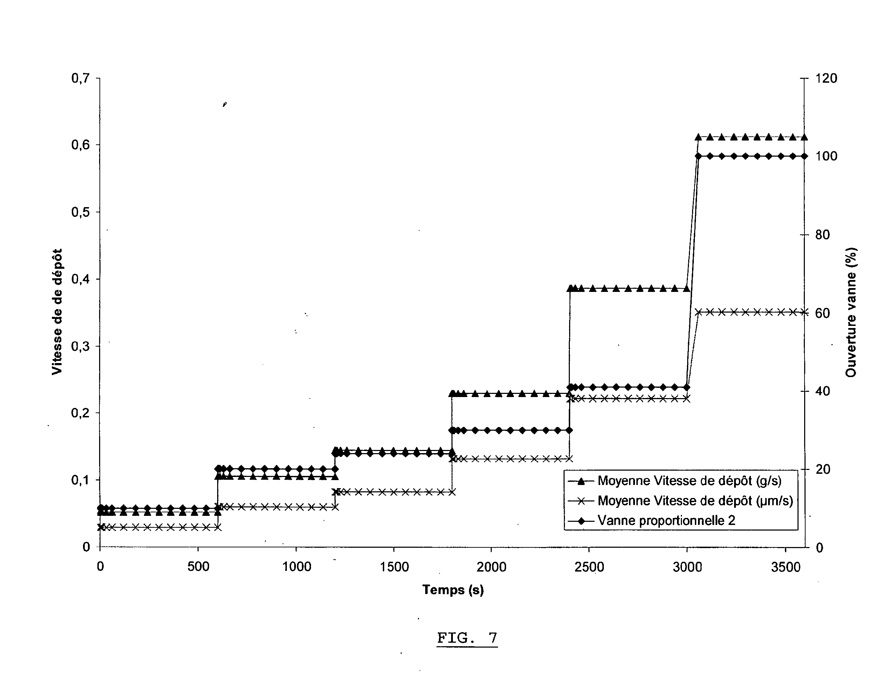

La figure 7 illustre l'utilisation d'une telle vanne papillon 5, avec éventuellement un dispositif de perte de charge 5A, pour la régulation du débit de vapeur. Les débits massiques sont constants pour une position de vanne donnée et les transitoires sont quasi inexistants.

Un autre avantage important est que toute la partie extérieure à l'enceinte sous vide 6 est accessible, le désavantage étant cependant la réalisation obligatoire de l'étanchéité au vide et à haute température au niveau des jonctions dans la partie déportée (non représenté).

Pour chauffer le creuset, la conduite et l'éjecteur, on utilise un four extérieur par rayonnement (de type four cylindrique à fils ou résistances rayonnants). De tels fours sont utilisés en laboratoire jusqu'à une température de 1400-1500°C. Ce four est donc très robuste vu que la température de travail habituelle pour cette application est de l'ordre de 700°C.

Grâce à ce four à rayonnement, la vapeur est surchauffée, ce qui permet de s'éloigner de la température de pression de vapeur saturante et donc du point de condensation. Le risque de recondensation diminue donc. De plus, des simulations numériques ont été effectuées pour déterminer la gamme des vitesses permettant d'éviter la détente adiabatique et donc la condensation suite à la diminution de température qui en découle.

Le fait d'utiliser un chauffage par l'extérieur de la chambre à vide, avec calorifugeage approprié, présente un certain nombre d'avantages :
- maintenance aisée du système de chauffage ;
- isolation et calorifugeage se trouvant à l'extérieur de la chambre à vide, limitant les phénomènes de dégazage sous vide ;
- réduction des problèmes liés à l'utilisation d'éléments chauffants sous vide et liés au refroidissement de leurs connexions électriques ;
- limitation du nombre de cartouches de chauffage sous vide à l'éjecteur, avec limite d'utilisation plus haute (meilleure tenue dans le temps). Par exemple deux cartouches de chauffage à 1100°C sont suffisantes dans le cas du chauffage par rayonnement ;
- utilisation de techniques de chauffage et d'éléments de chauffage robustes et fiables.

### Description de formes d'exécution préférées de l'invention Installation générale

Selon une forme d'exécution préférée de l'invention, représentée sur la figure 1B, un creuset cylindrique 1, contenant du magnésium fondu, est délocalisé hors de la cuve 6 et en communication avec une tête JVD, en guise d'éjecteur de vapeur de magnésium présentant une fente de sortie disposée transversalement sur toute la largeur de la bande. Selon l'invention, cette dernière peut être disposée indifféremment en brin vertical ou horizontal. Le pompage du magnésium du four de fusion vers le creuset est réalisé au moyen d'une pompe, mais peut également se faire de manière plus simple par dépression, la pression du creuset étant alors inférieure à celle du four de fusion. Les moyens de régulation et l'instrumentation sont disposés hors vide.

L'avantage de ce dispositif est qu'il n'y a pas de magnésium liquide stocké dans la cuve de dépôt, ce qui réduit les inerties, ni de ségrégation de particules d'impuretés sous vide. La conduite 4 de transfert de vapeur est équipée d'un chauffage. La répartition de la vapeur de magnésium sur la largeur de la bande (avant la fente d'éjection) et assurée par un milieu filtrant 3A situé dans l'éjecteur. Cet organe assure en outre la filtration et le réchauffement de la vapeur qui le traverse. Par exemple, ce milieu filtrant peut être un filtre en titane fritté.

### Creuset proprement dit

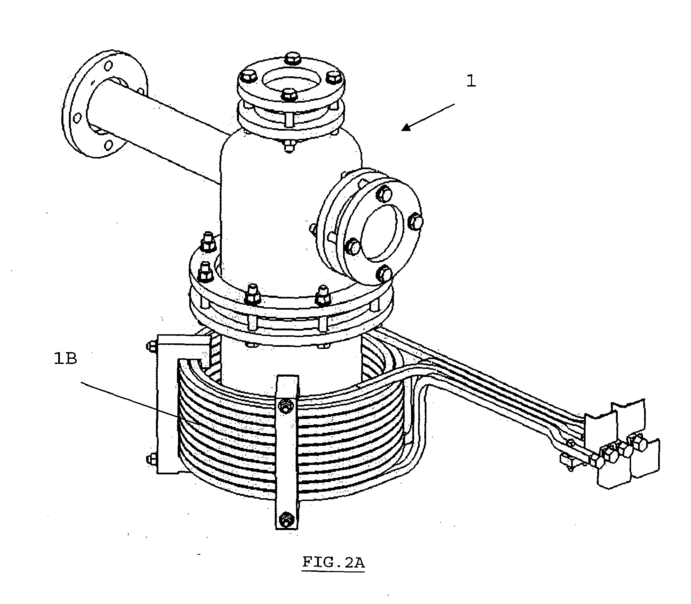

Le creuset 1 selon une forme préférée de l'invention représentée en détail sur la figure 2A, est unique et est facilement accessible pour toute intervention de maintenance. Il est inerte au contact à haute température avec le métal liquide pour sa surface intérieure et résistant à l'oxydation à l'air pour sa surface extérieure.
Il sera de préférence en inox revêtu ou en tout matériau compatible avec le métal à évaporer et avec le contact à l'air à haute température, pour sa partie extérieure. On pourra ainsi choisir par exemple dans le cas du magnésium un colaminé inox-fer doux.

Le chauffage du creuset 1 est conventionnel et réalisé par induction 1B. La fréquence est avantageusement comprise entre 400 et 1000 Hz. D'autres caractéristiques du dispositif mis en oeuvre sont une montée en température de 20 min, taux de chauffage direct du magnésium > 60%, une vitesse de brassage > 1 m/s, etc.

L'inertie thermique est réduite. Le dispositif est pourvu d'une purge du creuset vers le four de fusion par écoulement gravitaire ou pompage, en cas de problème (non représenté).

La régulation du niveau de magnésium dans le creuset est avantageusement réalisée par des moyens de mesure de masse (pesons).

### Ejecteur

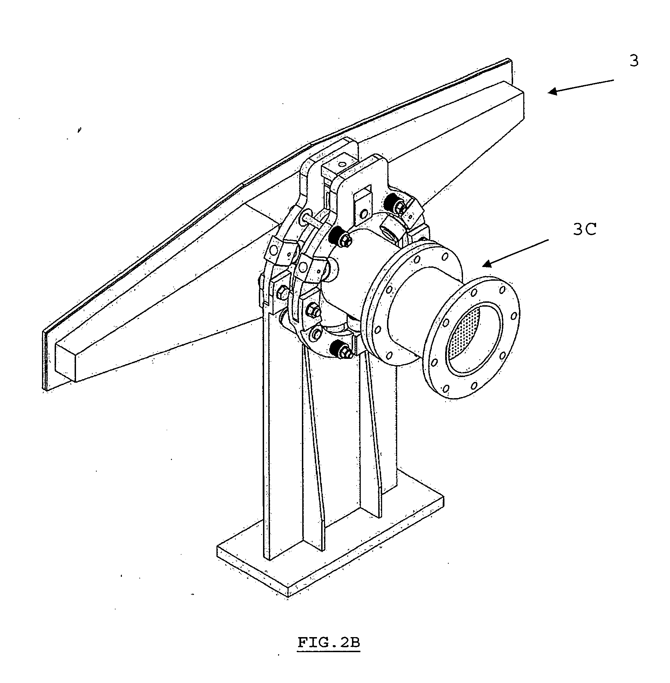

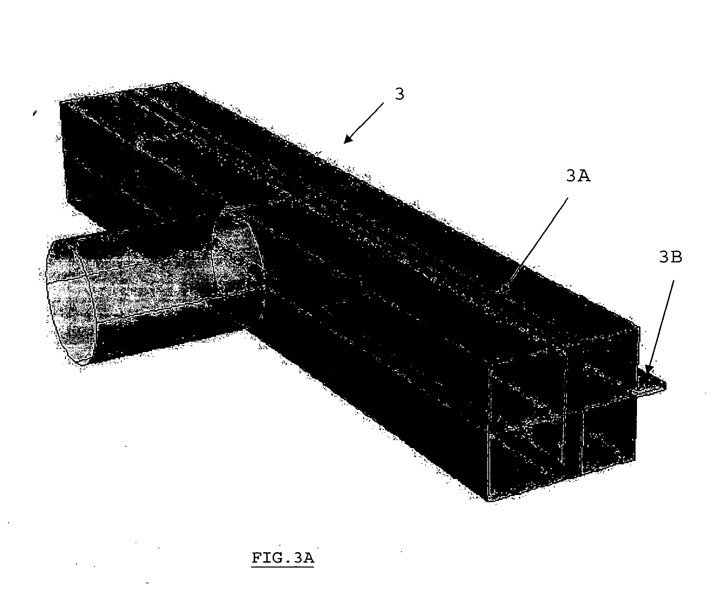

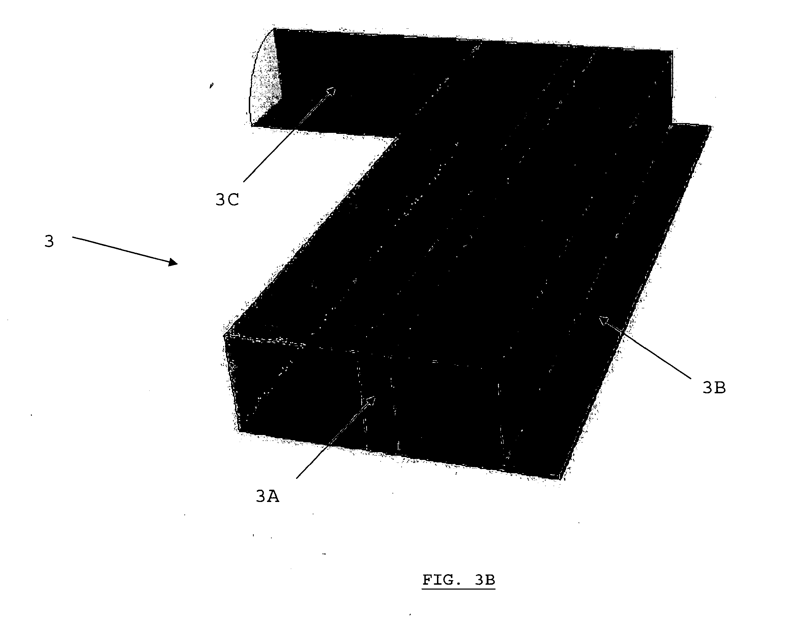

L'éjecteur 3 est représenté en détail sur les figures 2B et 3A à 3C. Il s'agit d'une boîte de longueur supérieure à la largeur de la bande à revêtir. Ce dispositif contient un milieu filtrant ou créant une perte de charge 3A et assurant ainsi l'uniformisation du débit de vapeur sur toute la longueur de la boîte . L'éjecteur 3 est chauffé à température supérieure à celle de la vapeur métallique et est calorifugé extérieurement. Le chauffage peut être interne par cartouches (choix adopté dans la présente forme d'exécution) mais peut également être externe par résistances rayonnantes. Une fente calibrée assure la projection, à la vitesse du son, de la vapeur métallique sur la bande 7. Le col sonique sur toute la longueur de la fente complète très efficacement le milieu filtrant 3A pour assurer l'uniformité du dépôt sur la bande. L'adaptation à la largeur de la bande 7 se fait par rotation de l'éjecteur autour de sa conduite d'alimentation 3B. La figure 2B représente la mécanique interne à la cuve de dépôt qui est alors très simplifiée et fiable. La régulation du débit de vapeur est assurée par la vanne 5 située sur la conduite circulaire 4 (voir figure 1B). Comme déjà mentionné, la figure 7 illustre un exemple de régulation qui peut être réalisée.

### Résultats de simulations et d'essais obtenus avec une installation pilote

Le tableau 1 donne les paramètres d'une installation pilote réalisée pour la mise en oeuvre de l'invention, en comparaison avec les paramètres d'une installation industrielle typique dans le cadre d'une application de dépôt de magnésium.

**Tableau 1**

| | Solution Industrielle | Solution pilote |
|---|---|---|
| Diamètre creuset | 650 mm | 265 mm |
| Hauteur générateur | 1000mm | 500 mm |
| diamètres conduites | 250 mm | 100 mm |
| Température Travail | 690 - 750 °C | 690 - 750 °C |
| Températures parois | 750 °C | 750 °C |
| Pression de travail | 30 à 70 mbar | 30 à 70 mbar |
| Puissance induction | 160 kW | 50 kW |
| Etendue de travail | 2,5 | 2,5 |
| Volume métal liquide | 82 L | 18L |
| Ejecteur | 1600 mm | 450 mm |
| Fente | 10 mm | 5 mm |
| Pression éjecteur | qques mmbar | qques mmbar |

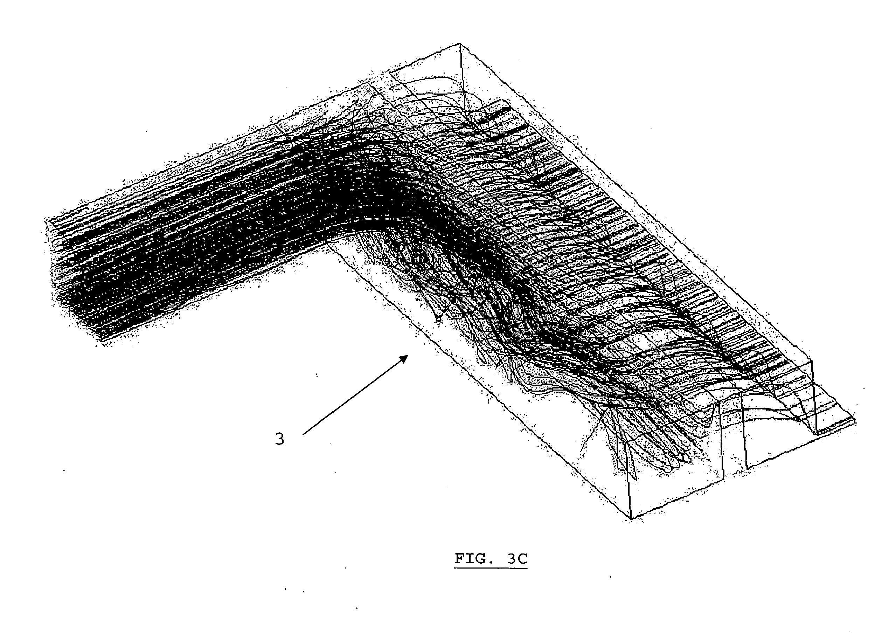

Les figures 3A à 3C montrent différentes vues en perspective de l'éjecteur 3 muni de son filtre en titane fritté 3A et de la fente d'éjection 3B. La figure 3C montre une simulation des trajectoires de vapeur dans la tête d'éjection.

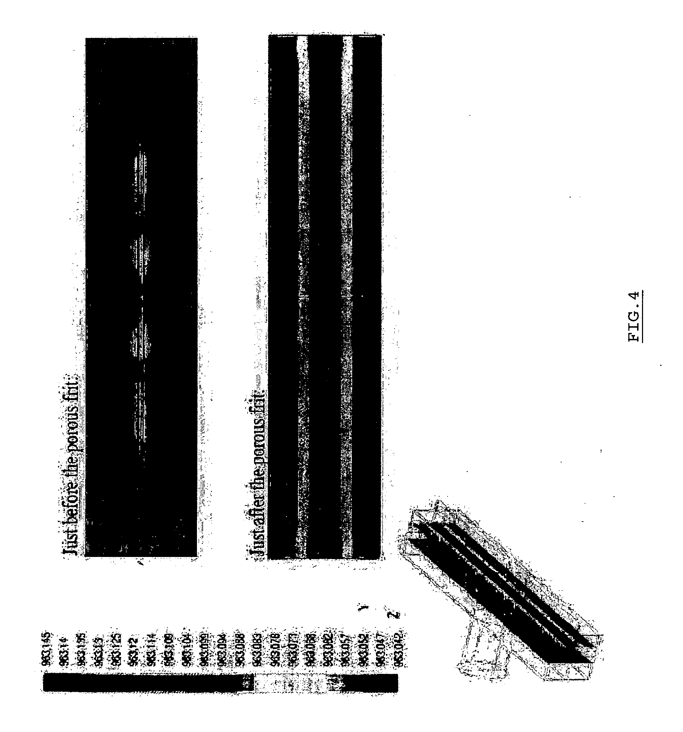

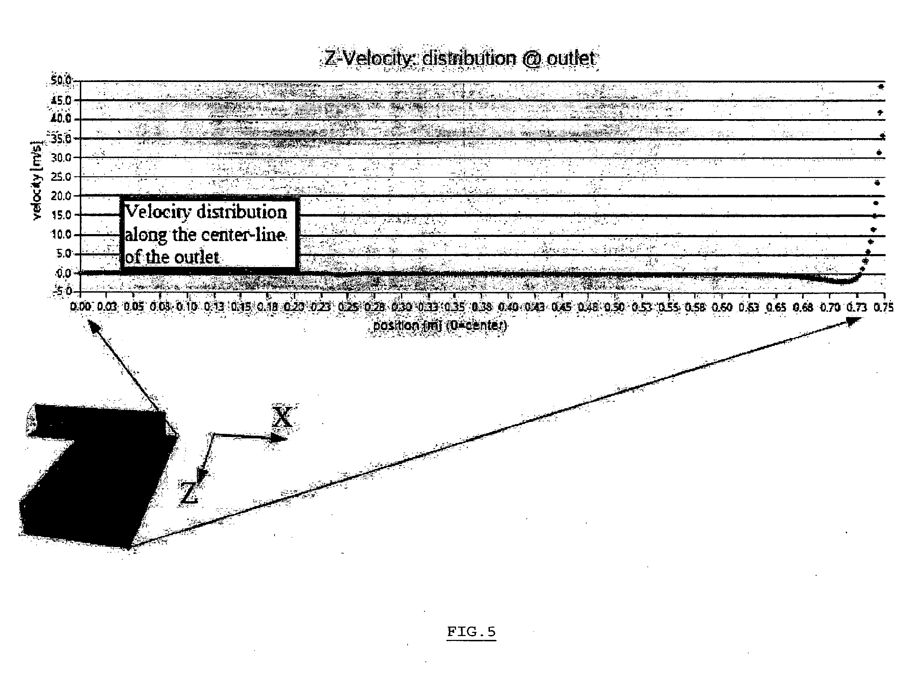

Des résultats d'une simulation numérique en mécanique des fluides, appliquée à l'éjecteur, sont représentés sur les figures 4 et 5. Les différences de température de vapeur avant, et après le filtre fritté sont très faibles (0,103K, voir figure 4). De plus, la distribution des vitesses le long de la ligne centrale de sortie est pratiquement constante, la direction de la vitesse ne variant significativement que tout près de l'extrémité de la tête (figure 5). Ainsi, le jet de vapeur est presque parfaitement uniforme et isotherme. Le dépôt de vapeur métallique sur la bande sera uniforme en épaisseur et structure cristalline.

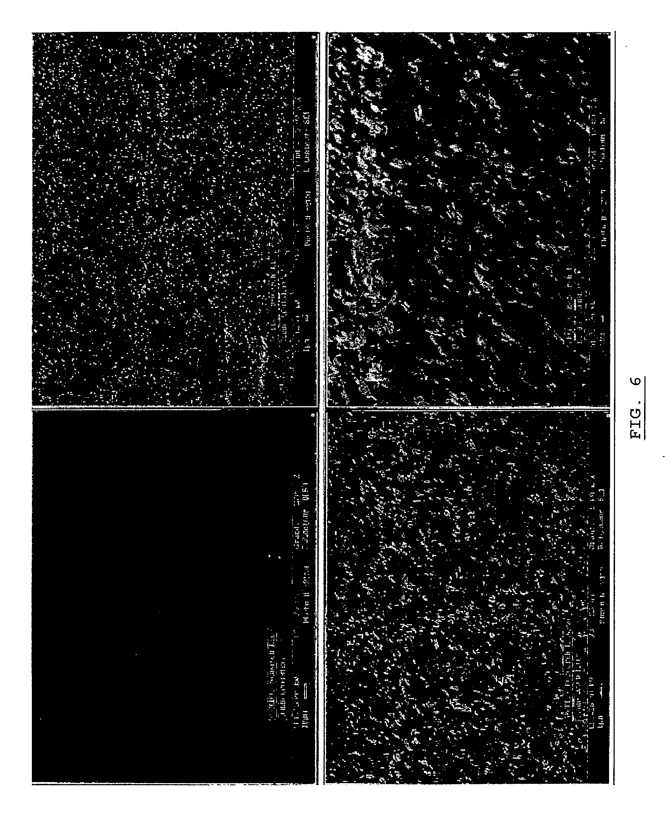

La figure 6 montre, à différents grandissements, le revêtement d'un échantillon de fer noir par du magnésium, obtenu avec l'installation pilote précitée. On peut y constater la bonne homogénéité du dépôt.

D'autre part, le dispositif déporté selon l'invention est particulièrement adapté au dépôt d'alliage par mélange de vapeur car il permet d'ajuster la composition chimique déposée sans avoir à modifier la composition d'un alliage liquide. Le mélange se fait alors dans une conduite à très basse vitesse d'écoulement contrairement à l'état de l'art.

### Mélange des vapeurs de deux métaux de recouvrement différents

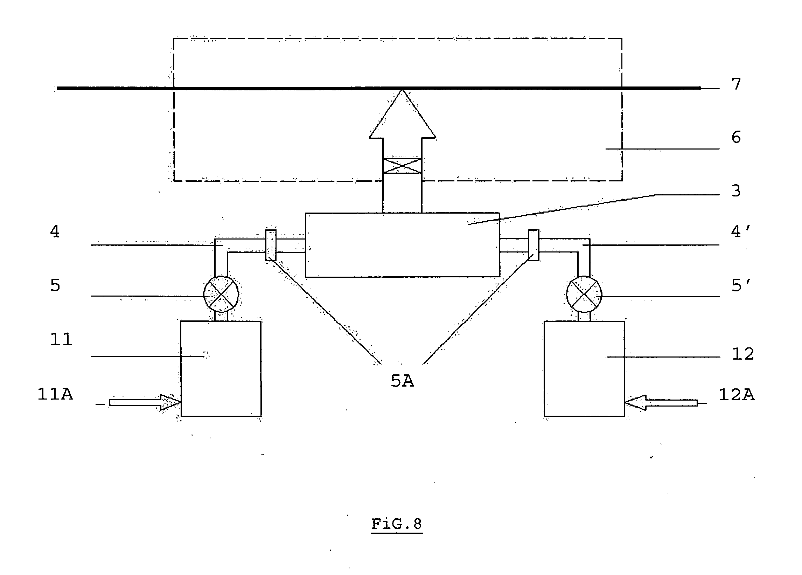

Comme représenté sur la figure 8, deux chambres de fusion 11, 12 contenant respectivement deux métaux purs différents (par exemple zinc et magnésium) sont reliées chacune par une conduite 4, 4' munie d'une vanne 5, 5' à une chambre de mélange couplée à l'éjecteur 3. La concentration des deux métaux dans le mélange est ajustée au moyen des vannes proportionnelles respectives 5, 5', ce qui simplifie le problème de gestion. L'encombrement de ce système est avantageusement réduit.

Un système de perte de charge 5A est utilisé sur chaque conduite, coopérant avec les vannes respectives, ce qui permet un bon brassage magnétique et l'obtention d'une vapeur à pression plus haute qu'en l'absence de ce système (ex. 20 mbar à 700°C).

Ce dispositif permet également de réguler le débit de vapeur de façon fine et rapide.

### Avantages de l'invention

Le système selon l'invention permet l'obtention d'une très bonne uniformité de la température et de la vitesse de la vapeur déposée, tout en étant fiable et accessible et en ayant de très faibles temps de réponse. L'invention répond ainsi très bien aux exigences d'industrialisation du procédé. Une régulation à basse fréquence du chauffage par induction assure une très bonne uniformité en composition et en température dans le creuset et la régulation du débit de vapeur se fait simplement au moyen d'une vanne située au niveau de la conduite reliant le creuset d'évaporation et l'éjecteur de dépôt et en ajustant l'énergie transmise au métal. Dans WO-A-2005/116290, la régulation du niveau de liquide sous vide y compris à l'intérieur de la chambre d'évaporation, est effectuée grâce à une pompe magnétohydrodynamique. Contrairement à cet état de la technique, la régulation de niveau selon l'invention se fait par pesée du creuset et la chambre de distribution selon l'invention est un système JVD muni d'une fente ne contenant que de la vapeur du métal à déposer.

## Revendications

1. Générateur de vapeur pour le dépôt d'un revêtement métallique sur un substrat (7), de préférence une bande d'acier, comprenant une chambre à vide (6) sous forme d'une enceinte, munie de moyens pour y assurer un état de dépression par rapport au milieu extérieur et munie de moyens permettant l'entrée et la sortie du substrat (7), tout en étant essentiellement étanche par rapport au milieu extérieur, ladite enceinte englobant une tête de dépôt de vapeur, appelée éjecteur (3), conformé pour créer un jet de vapeur métallique à la vitesse sonique en direction de et perpendiculaire à la surface du substrat (7), ledit éjecteur (3) étant en communication de manière étanche au moyen d'une conduite d'alimentation (4) avec au moins un creuset (1, 11, 12) contenant un métal de revêtement sous forme liquide et situé à l'extérieur de la chambre à vide (6), **caractérisé en ce que** ledit générateur de vapeur comprend des moyens pour réguler le débit, la pression et/ou la vitesse de la vapeur métallique dans l'éjecteur (3).

2. Générateur selon la revendication 1, **caractérisé en ce que** lesdits moyens de régulation comprennent une vanne (5) et/ou un dispositif de perte de charge (5A) disposés dans ladite conduite (4).

3. Générateur selon la revendication 2, **caractérisé en ce que** la vanne (5) est une vanne proportionnelle, de préférence de type papillon.

4. Générateur selon la revendication 1, 2 ou 3, **caractérisé en ce que** l'éjecteur (3) comprend une fente longitudinale de sortie de la vapeur, jouant le rôle de col sonique, s'étendant sur toute la largeur du substrat et un milieu filtrant ou un organe de perte de charge (3A) pouvant être un filtre fritté, de préférence en titane, de sorte à uniformiser et redresser les vecteurs vitesse de la vapeur sortant de l'éjecteur (3).

5. Générateur selon la revendication 4, **caractérisé en ce qu'**il comporte des moyens pour ajuster la longueur de la fente à la largeur du substrat.

6. Générateur selon la revendication 5, **caractérisé en ce que** lesdits moyens comprennent des moyens de rotation de l'éjecteur (3) autour de sa conduite d'alimentation (4).

7. Générateur selon l'une quelconque des revendications précédentes, **caractérisé en ce que** le creuset (1) contient un mélange de métaux sous forme liquide.

8. Générateur selon l'une quelconque des revendications précédentes, **caractérisé en ce que** le creuset (1) est alimenté par pompage ou par gravité du métal liquide à partir d'un four de fusion (2).

9. Générateur selon l'une quelconque des revendications précédentes, **caractérisé en ce que** le creuset (1) comporte un inducteur (1B) monté à l'extérieur, pour assurer le brassage magnétique du métal liquide.

10. Générateur selon l'une quelconque des revendications précédentes, **caractérisé en ce que** le creuset (1) comporte une purge vers le four de fusion (2) par pompage ou écoulement gravitaire.

11. Générateur selon l'une quelconque des revendications précédentes, **caractérisé en ce que** le creuset (1) comporte des moyens de mesure de masse extérieurs pour y réguler le niveau de métal liquide.

12. Générateur selon l'une quelconque des revendications précédentes, **caractérisé en ce que** l'éjecteur (3), la conduite (4) et le creuset (1) sont isolés thermiquement du milieu extérieur et chauffés par un four à rayonnement.

13. Générateur selon l'une quelconque des revendications précédentes, **caractérisé en ce qu'**il comporte des moyens de chauffage optionnels de l'enceinte sous vide (6).

14. Générateur selon la revendication 1, **caractérisé en ce qu'**il comporte deux creusets (11, 12) contenant des métaux sous forme liquide différents.

15. Générateur selon la revendication 14, **caractérisé en ce que** chaque creuset (11, 12) est relié par une conduite propre (4, 4') à un mélangeur, lui-même en communication avec l'éjecteur (3).

16. Générateur selon la revendication 15, **caractérisé en ce que** chaque conduite (4, 4') comporte une vanne (5, 5') et/ou un dispositif de perte de charge (5A) permettant l'ajustement des concentrations de chaque métal lors du mélange des vapeurs à déposer sur le substrat (7).

17. Générateur selon la revendication 16, **caractérisé en ce que** le mélangeur est l'éjecteur (3) lui-même et comporte un milieu filtrant pouvant être un filtre fritté permettant d'uniformiser et redresser les vecteurs vitesse de la vapeur de chaque métal sortant de l'éjecteur(3).
